# EUROPEAN PATENT APPLICATION

(11) **EP 4 613 995 A1**
(43) Date of publication of application: **10.09.2025**
(21) Application number: 25161596.9
(22) Date of filing: 04.03.2025
(51) Int. Cl.: F02C 7/14, B64D 27/33, F02K 3/06

(54) **ENERGY GENERATING DEVICE**

(30) Priority: 04.03.2024 US 202418594925
(71) Applicant: PRATT & WHITNEY CANADA CORP., Longueuil, Québec J4G 1A1 (CA)
(72) Inventor: AL-KHAIRY, Issam, (01BE5) Longueuil, J4G 1A1 (CA)
(74) Representative: Dehns

(57) **Abstract**

An aircraft (20) propulsion system (26) is provided that includes a thermal engine (36) and an electrical energy generating device (62). The electrical energy generating device (62) has first and second fluid conduits (64, 66) and a thermoelectric generator, TEG (68). The TEG (68) is disposed between the first and second fluid conduits (64, 66). A first side of the TEG (68) is in thermal communication with the first fluid conduit (64), and a second side of the TEG (68) is in thermal communication with the second fluid conduit (66). The TEG (68) is configured to produce electrical energy as a function of a temperature difference across the TEG (68). The first fluid conduit (64) contains a first fluid flow, and the second fluid conduit (66) contains a second fluid flow. During operation of the propulsion system (26), the first fluid flow is at a first higher temperature and the second fluid flow is at a second lower temperature, thereby producing the temperature difference across the TEG (68).

## Description

### BACKGROUND OF THE INVENTION

### 1. Technical Field

This invention relates generally to an energy generating device for a turbine engine, and more particularly, an energy generating device that converts thermal energy into electrical energy.

### 2. Background Information

Interest in alternative options for power generation continues to grow. While power plants including electric power supplies and engines exist, other opportunities for harnessing energy are desired. In many aspects of power generation, thermal energy is created. Heat exchangers utilize thermal energy to heat (e.g., elevate temperature from ambient) or cool (e.g., decrease temperature from ambient) fluids (or engine components) germane to turbine engine function. Heat exchangers include, for example, a fuel-oil heat exchange (FOHE), a fuel-air heat exchange, or other fluid-fluid heat exchange. Such exchange leads to the transfer of thermal energy, and there is a need to make further use of such thermal energy for generating electrical energy.

### SUMMARY OF THE INVENTION

According to an aspect of the present invention, an aircraft propulsion system is provided that includes a thermal engine and an electrical energy generating device. The thermal engine is configured to produce thrust. The electrical energy generating device has a first fluid conduit, a second fluid conduit, and a thermoelectric generator (TEG). The TEG is disposed between the first and second fluid conduits with a first side of the TEG adjacent the first fluid conduit and a second side of the TEG adjacent the second fluid conduit. The first side of the TEG is in thermal communication with the first fluid conduit, and the second side of the TEG is in thermal communication with the second fluid conduit. The TEG generator is configured to produce electrical energy as a function of a temperature difference across the TEG between the first and second sides of the TEG. The first fluid conduit is configured to contain a first fluid flow, and the second fluid conduit is configured to contain a second fluid flow. During operation of the propulsion system, the first fluid flow is at a first temperature and the second fluid flow is at a second temperature, and the first temperature is higher than the second temperature, thereby producing the temperature difference across the TEG between the first side of the TEG and the second side of the TEG.

Optionally, and in accordance with the above, the system may include a lubrication system configured to cycle a lubricant flow within the propulsion system, wherein the first fluid flow is the lubricant flow.

Optionally, and in accordance with any of the above, the system may include a fuel system configured to provide a fuel flow to the thermal engine, wherein the second fluid flow is the fuel flow.

Optionally, and in accordance with any of the above, the thermal engine may be a gas turbine engine that is disposed within a nacelle, and the gas turbine engine may include a fan section, a compressor section, a combustion section, a turbine section, and an engine casing disposed radially outside of the compressor section, the combustion section, and the turbine section. An annular bypass duct may be defined between the engine casing and an interior structure of the nacelle, and the bypass duct may be configured to contain a bypass flow during operation of the propulsion system, and the second fluid flow may be the bypass flow.

Optionally, and in accordance with any of the above, the bypass duct may be the second fluid conduit.

Optionally, and in accordance with any of the above, the thermal engine is a gas turbine engine that includes a fan section, a compressor section, a combustion section, a turbine section, and a core gas path that extends through the compressor section, the combustion section, and the turbine section. The core gas path may be configured to contain a core gas flow during operation of the propulsion system, and the second fluid flow may be the core gas flow.

Optionally, and in accordance with any of the above, the core gas path may be the second fluid conduit.

Optionally, and in accordance with any of the above, the TEG may be configured to use a Seebeck effect.

According to another aspect of the present invention, a hybrid electric propulsion (HEP) system for an aircraft is provided that includes a thermal engine, an electric motor, a gearbox, an electric power storage unit, and an electrical energy generating device. The gearbox is in communication with the thermal engine and the electric motor. The electrical energy generating device has a first fluid conduit, a second fluid conduit, and a thermoelectric generator (TEG). The TEG is disposed between the first and second fluid conduits with a first side of the TEG adjacent the first fluid conduit and a second side of the TEG adjacent the second fluid conduit. The first side of the TEG is in thermal communication with the first fluid conduit, and the second side of the TEG is in thermal communication with the second fluid conduit. The TEG generator is configured to produce electrical energy as a function of a temperature difference across the TEG between the first and second sides of the TEG. The first fluid conduit is configured to contain a first fluid flow, and the second fluid conduit is configured to contain a second fluid flow. During operation of the HEP system, the first fluid flow is at a first temperature and the second fluid flow is at a second temperature, and the first temperature is higher than the second temperature, thereby producing the temperature difference across the TEG between the first and second sides of the TEG.

Optionally, and in accordance with any of the above, the HEP system may include a lubrication system configured to cycle a lubricant flow within the HEP system, wherein the first fluid flow is the lubricant flow.

Optionally, and in accordance with any of the above, the HEP system may include a fuel system configured to provide a fuel flow to the thermal engine, wherein the second fluid flow is the fuel flow.

According to another aspect of the present invention, a method of generating electrical energy within a propulsion system of an aircraft is provided. The method includes; providing a propulsion system having a thermal engine; providing an electrical energy generating device having a first fluid conduit, a second fluid conduit, and a thermoelectric generator (TEG), wherein the TEG is disposed between the first fluid conduit and the second fluid conduit with a first side of the TEG adjacent the first fluid conduit and a second side of the TEG adjacent the second fluid conduit, and wherein the first side of the TEG is in thermal communication with the first fluid conduit, and the second side of the TEG is in thermal communication with the second fluid conduit, and wherein the TEG generator is configured to generate electrical energy as a function of a temperature difference across the TEG between the first side of the TEG and the second side of the TEG; and using the electrical energy generating device to generate electrical energy by: directing a first fluid flow through the first fluid conduit during operation of the propulsion system, wherein the first fluid flow is at a first temperature; and directing a second fluid flow through the second fluid conduit during operation of the propulsion system, wherein the second fluid flow is at a second temperature, and the first temperature is higher than the second temperature, thereby producing the temperature difference across the TEG between the first side of the TEG and the second side of the TEG, which in turn causes the TEG to generate electrical energy.

The foregoing features and elements may be combined in various combinations without exclusivity, unless expressly indicated otherwise. For example, aspects and/or embodiments of the present invention may include any one or more of the individual features or elements disclosed above and/or below alone or in any combination thereof. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

FIG. 1 is a diagrammatic illustration of an aircraft.
FIG. 2 is a diagrammatic illustration of a hybrid electric propulsion system that may be used or included with embodiments of the present invention.
FIG. 3 is a diagrammatic illustration of a turbine engine that may be used or included with embodiments of the present invention.
FIG. 4 is a diagrammatic illustration of an energy generating device embodiment.
FIG. 5 is a diagrammatic illustration of an energy generating device embodiment.
FIG. 6 is a diagrammatic partial view of the turbine engine shown in FIG. 3, enlarged and modified to show an embodiment of an energy generating device.
FIG. 7 is a diagrammatic partial view of the turbine engine shown in FIG. 3, enlarged and modified to show an embodiment of an energy generating device.
FIG. 8 is a diagrammatic partial view of the turbine engine shown in FIG. 3, enlarged and modified to show an embodiment of an energy generating device.
FIG. 9 diagrammatically illustrates an energy generating device embodiment.

### DETAILED DESCRIPTION

The present invention is directed to energy generating devices that may be used within an aircraft propulsion system and/or to aircraft propulsion system that incorporate an energy generating device as detailed herein.

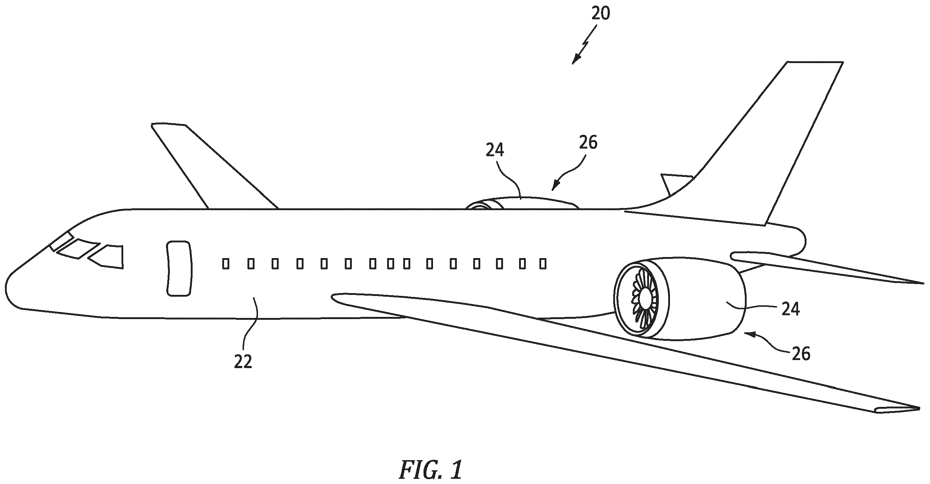

FIG. 1 illustrates a conventional fixed wing aircraft 20 that may utilize embodiments of the present invention. The aircraft 20 includes a fuselage 22 and a pair of nacelles 24. Each nacelle 24 houses a propulsion system 26 that provides thrust for the aircraft 20.

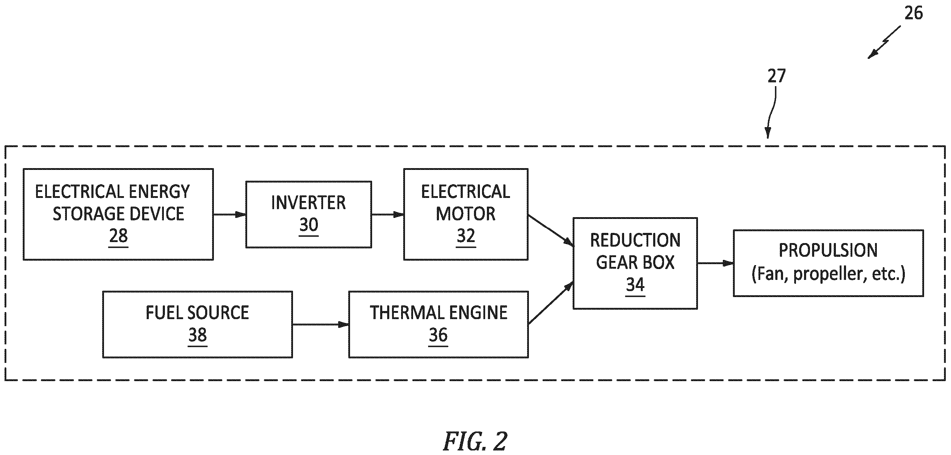

FIG. 2 diagrammatically illustrates an example of a propulsion system 26 in the form of a hybrid-electric propulsion (HEP) system 27. The HEP system 27 includes an electrical energy storage device 28 (e.g., a battery), an inverter 30, an electrical motor 32, a reduction gear box 34, a thermal engine 36, and a fuel source 38 for the thermal engine 36. The electrical motor 32 may be an alternating current (AC) motor configured to rotationally drive a component. For example, the electrical motor 32 may be configured to rotationally drive at least a portion of a gearbox 34 (e.g., see FIG. 2), or may be configured to provide rotational drive to a thermal engine 36, or the like. The electrical energy storage device 28 is configured to selectively store electrical energy in a first operational mode (i.e., a charging mode), and to produce electrical energy in a second operational mode (i.e., a discharging mode). An example of an electric energy storage device 28 is one that includes one or more batteries. Electric electrical energy storage devices 28 other than batteries may be used in some embodiments. The inverter 30 may be a part of a control system that includes hardware and controls for providing electrical power to the electrical motor 32. The present invention is not limited to use with any particular HEP system 27 configuration.

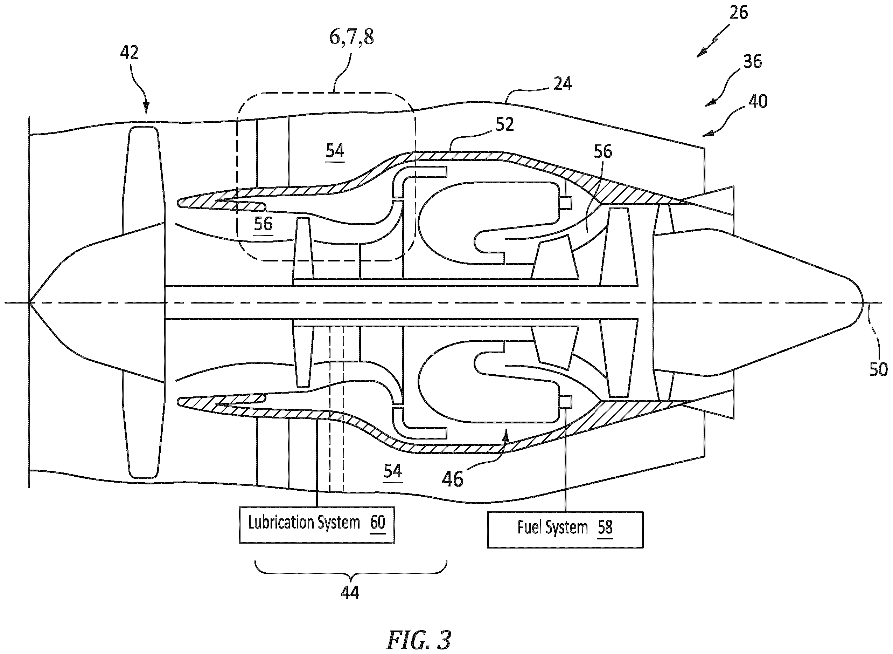

FIG. 3 diagrammatically illustrates a thermal engine 36 in the form of a turbine engine 40 disposed within a nacelle 24. The turbine engine 40 itself may be the propulsion system 26 or, as indicated above, it may be part of a HEP system 27. The engine 40 includes a fan section 42, a compressor section 44, a combustion section 46, and a turbine section 48. The engine 40 may be described as having a rotational axis 50. The engine 40 is shown diagrammatically including an engine casing 52 disposed radially outside of the compressor, combustion, and turbine sections 44, 46, 48. An annular bypass duct 54 is defined between the engine casing 52 and an interior structure of the nacelle 24. Air entering the forward / upstream end of the nacelle 24, passes through the fan section 42. A portion of the air worked within the fan section 42 enters the compressor section 44 and travels generally axially through the compressor, combustor, and turbine sections 44, 46, 48. This gas path is referred to typically as the "core gas path 56". The remainder of the air worked within the fan section 42 enters the bypass duct 54 and is typically referred to as "bypass air". Both the bypass air and the core gas produce thrust that may be used for propulsion. The present invention is not limited to the example of a thermal engine 36 shown in FIG. 3. For example, in those embodiments wherein the thermal engine 36 is a turbine engine 40, the turbine engine 40 may be configured as a geared turbine engine that drives the fan section 42 (or a propeller) of a propulsion system 26 at a lower rotational speed than the rotational speed of an engine shaft.

In those propulsion systems 26 that include a thermal engine 36, a fuel system 58 is included that provides fuel from a fuel storage device (e.g., a fuel tank - not shown) to the portion of the engine 36 where fuel is combusted within the engine; e.g., the combustion section 46 of the example turbine engine 40. Typically, the fuel is pumped from the fuel storage device (e.g., by a mechanical pump, or an electro-mechanical pump, or the like) to the point of combustion through piping or other type of fluid conduit. The present invention is not limited to particular type of fuel (e.g., aviation gas, kerosene, sustainable aviation fuel (SAF), or the like) and is not limited to any particular fuel system configuration, other than is described herein.

A propulsion system 26 that includes the present invention may include a lubrication system 60 for a thermal engine 36 and/or for other components within a HEP system 27. The lubrication system 60 is configured to cycle a lubricant (e.g., engine oil) from a lubricant storage device (e.g., an oil tank - not shown) to the system components (e.g., bearing housings, gearboxes, and the like) where the lubricant is utilized for lubrication purposes and/or cooling purposes, and return the lubricant back to the storage device. Typically, the lubricant is pumped from an lubricant tank (e.g., by a mechanical pump, or an electro-mechanical pump, or the like) to the various components that require lubrication. The present invention is not limited to particular type of lubricant (e.g., conventional engine oil, synthetic engine oil, or the like - collectively referred to hereinafter generically as "oil") and is not limited to any particular lubrication system 60 configuration, other than is described herein.

In some embodiments, the present invention may be used with an all-electric propulsion system that utilizes an electric motor to power a propulsion unit (e.g., a propeller). The all-electric propulsion system may include mechanical components (e.g., reduction gearboxes and the like) and a lubrication system for servicing those mechanical components.

The terms "forward", "leading", "aft, "trailing" are used herein to indicate the relative position of a component or surface. As core gas air passes through the engine, a "leading edge" of a stator vane or rotor blade encounters core gas air before the "trailing edge" of the same. In an engine 40 like that shown in FIG. 3, the fan section 42 is "forward" of the compressor section 44 and the turbine section 48 is "aft" of the compressor section 44. The terms "upstream" and "downstream" used herein refer to the direction of a gas flow passing through an annular gas path of the turbine engine 40. It should also be noted that the terms "radial" and "circumferential" are used herein with respect to the rotational axis 50 of the turbine engine 40.

Aspects of the present invention include an electrical energy generating device ("EGD") 62 that utilizes a temperature difference / thermal gradient between a first fluid and a second fluid to generate electrical energy that may be used within the propulsion system 26, or within the aircraft 20, or both. For example, electrical energy produced by an EGD 62 may be utilized to provide electrical energy to electrical needs within the aircraft cabin (e.g., lighting, environmental controls, and the like) and/or propulsion system 26 electrical needs; e.g., control devices, actuators, and the like. When used with a propulsion system 26 in the form of a HEP system 27, the electrical energy produced by an EGD 62 may be directed to the electrical energy storage device for charging purposes. The present invention is not limited to these examples of how EGD 62 generated electrical energy may be used.

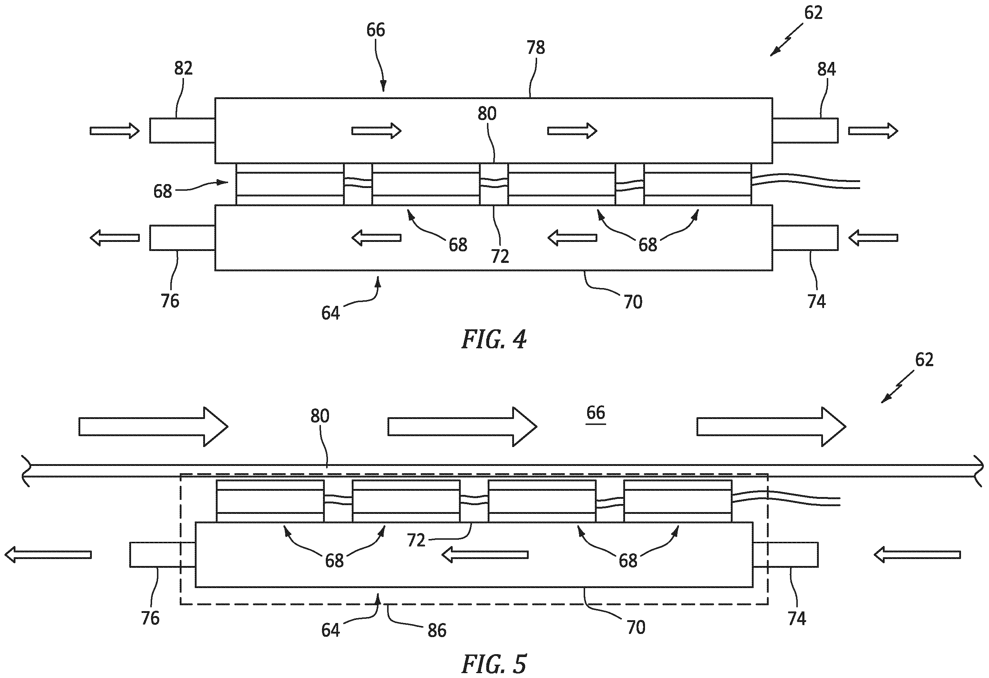

An example EGD 62 configuration is shown diagrammatically in FIG. 4. In this configuration, the EGD 62 includes a first fluid conduit 64, a second fluid conduit 66, and one or more thermoelectric generators (TEGs) 68 disposed between the first and second fluid conduits 64, 66. The first fluid conduit 64 includes a body 70 having an inner longitudinal panel 72, a fluid inlet 74, and a fluid outlet 76. In this embodiment, the first fluid conduit 64 is configured to contain a fluid that enters the fluid inlet 74, passes through the body 70, and exits the first fluid conduit 64 through the fluid outlet 76. The second fluid conduit 66 includes a body 78 having an inner longitudinal panel 80, a fluid inlet 82, and a fluid outlet 84. In this embodiment, the second fluid conduit 66 is configured to contain a fluid that enters the fluid inlet 82, passes through the body 78, and exits the second fluid conduit 66 through the fluid outlet 84. The first and second fluid conduits 64, 66 are shown diagrammatically within FIG. 4. The present invention is not limited to any particular first or second fluid conduit 64, 66 configuration other than one having a body 70, 78 with a fluid inlet 74, 82 and a fluid outlet 76, 84. In the embodiment shown in FIG. 4, the first fluid conduit 64 and the second fluid conduit 66 are diagrammatically configured to contain opposing fluid flows; e.g., a first fluid flow within the first fluid conduit 64 in a first direction, and a second fluid flow within the second fluid conduit 66 in a second direction opposite the first direction. The present invention is not limited this fluid conduit 64, 66 configuration. For example, in some embodiments the first and second conduits 64, 66 may be configured to contain fluid flows travelling in the same direction as one another. As another example, in some embodiments the first conduit 64 may be configured to contain a first fluid flow in a first direction, and the second conduit 66 may be configured to contain a second fluid flow in a second direction that is neither the same as nor opposite the first direction; e.g., the second direction may be orthogonal to the first direction. The present invention EGD 62 is not limited to any particular fluid flow configuration. The EGD 62 embodiment shown in FIG. 4 is configured such that the inner longitudinal panels 72, 80 of the first and second conduits 64, 66 face each and the TEGs 68 are disposed between the inner longitudinal panels 72, 80.

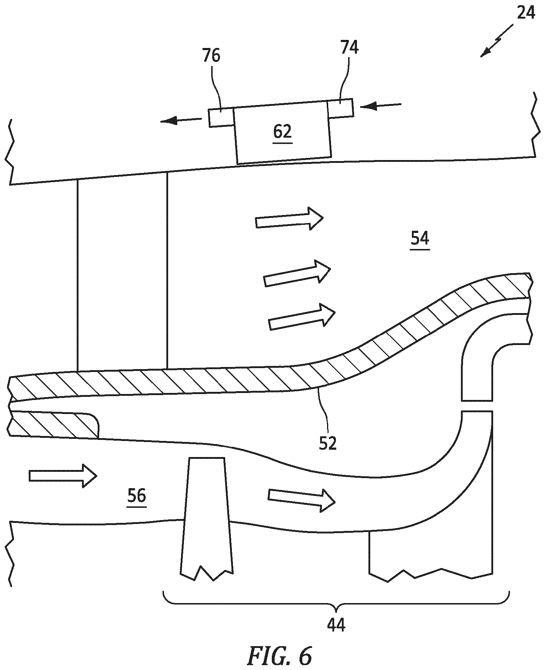

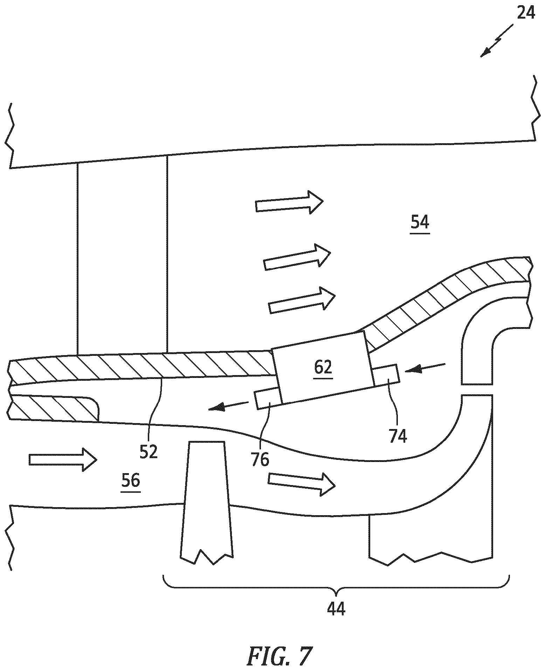

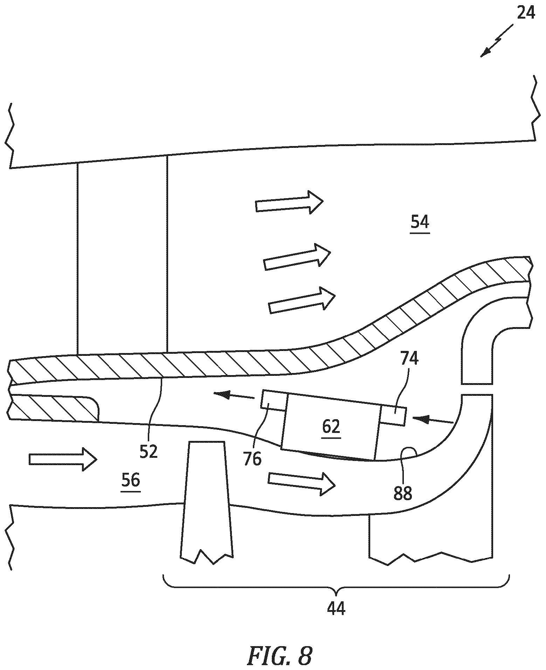

Another EGD 62 configuration example is diagrammatically shown in FIG. 5. In this configuration, the EGD 62 includes a first fluid conduit 64 and one or more TEGs 68. In some embodiments of this configuration, the EGD 62 may include a housing 86 (shown in dashed line) or similar structure to facilitate the EGD 62 having a unitary configuration. In this embodiment, the first fluid conduit 64 is configured to contain a fluid that enters the fluid inlet 74, passes through the body 70, and exits the first fluid conduit 64 through the fluid outlet 76. The EGD 62 is configured such that the TEGs 68 are disposed in thermal communication with the inner longitudinal panel 72 of the first fluid conduit 64. This EGD 62 embodiment is configured to be engaged with an existing fluid conduit; e.g., engaged with a wall of the nacelle 24 defining a portion of the bypass duct 54 (e.g., disposed outside of and contiguous with the bypass duct 54 as diagrammatically shown in FIG. 6), or a wall of the engine casing 52 (e.g., disposed contiguous with the bypass duct 54 as diagrammatically shown in FIG. 7), or a core gas flow path structural wall 88 (as diagrammatically shown in FIG. 8), or the like. In some embodiments, an EGD 62 may be disposed partially or fully within the core gas path 56 or bypass duct 54.

The TEGs 68 are configured to convert thermal energy into electrical energy and may be configured to use the Seebeck effect. The Seebeck effect is a phenomenon that occurs when a temperature difference exists between two different conductors or a circuit of conductors, creating an electric potential difference. TEGs 68 are solid-state devices that have no moving parts and can operate silently and reliably for long periods of time. In some embodiments, a TEG 68 may include thermoelectric materials that exhibit the Seebeck effect. Thermoelectric materials can be classified into two types: n-type and p-type. N-type materials have an excess of electrons, while p-type materials have a deficiency of electrons. When an n-type material and a p-type material are connected in series by metal electrodes, they form a thermocouple, which is the basic unit of a TEG 68. A TEG 68 may contain a plurality of thermocouples connected electrically in series and thermally in parallel. A temperature difference across the TEG 68 will cause an electrical current to flow through the TEG's circuit. The voltage and power output of a TEG 68 will depend on a number of factors, including the number of thermocouples within the TEG 68, the Seebeck coefficient of the thermoelectric materials, electrical resistance(s) of materials within the TEG 68, thermal resistance(s) of materials within the TEG 68, and the temperature difference across the TEG 68. The characteristics of TEGs 68 used within the present invention may be selected based on the application at hand. In some embodiments, a TEG 68 used within a present invention EGD 62 may be configured to use the Peltier effect or the Thomson effect as an alternative to the Seebeck effect, or may be configured to use some combination of the Seebeck, Peltier, and Thomson effects.

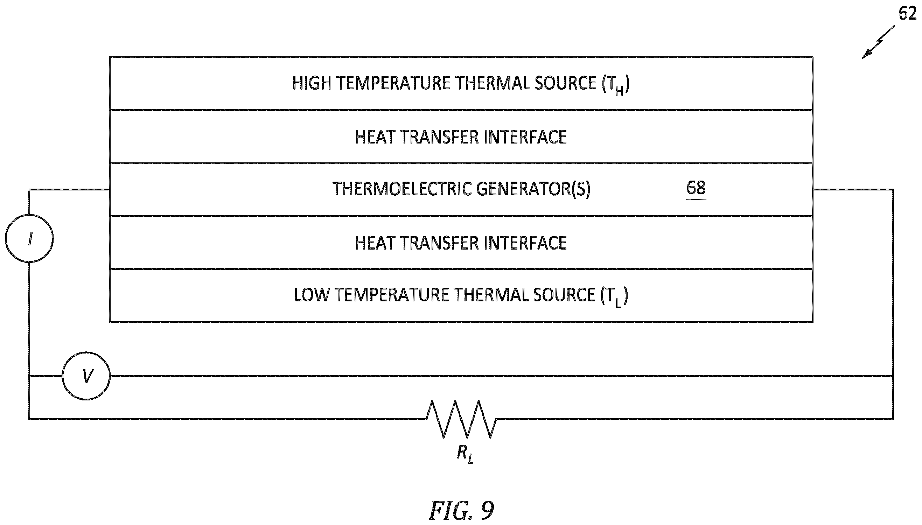

FIG. 9 diagrammatically illustrates an EGD 62 having a TEG 68 disposed between a high temperature thermal source at a high temperature (T_{H}; e.g., a first fluid) and a low temperature thermal source at a low temperature (T_{L}; e.g., a second fluid, where T_{H} > T_{L}). In the example diagrammatically shown in FIG. 9, heat transfer interfaces are shown disposed between the TEG 68 and the high temperature thermal source and between the TEG 68 and the low temperature thermal source. The heat transfer occurs from the high temperature thermal source to the low temperature thermal source and causes an electrical current to flow through the TEG's circuit. The present invention is not limited to any particular type of a TEG 68, or any particular TEG 68 configuration, other than those that may be used within the present invention embodiments described herein.

To illustrate the utility of the present invention, examples of the present invention will be detailed hereinafter in the context of a HEP system 27 that includes a turbine engine 40. As indicated herein, the present invention may be utilized with a variety of different propulsion systems 26 (e.g., HEP systems 27, thermal engine 40 propulsion systems, all-electric propulsion systems, and the like) and the present invention is not limited to the examples provided hereinafter. In addition, HEP systems 27 may be operated in a variety of different ways; e.g., the thermal engine 36 and the electric motor 32 may be operated in concert for an entire flight profile, or the thermal engine 36 may be operated for an entire flight profile and the electric motor 32 operated for portions of the flight profile, or the like. The present invention is not limited to any particular HEP system 27 operational scheme.

During operation of the turbine engine 40, air enters the turbine engine 40 through an airflow inlet and is directed through the fan section 42. The airflow exiting the fan section 42 either passes into the bypass duct 54 or enters the core gas path 56. Bypass airflow passing through the bypass duct 54 produces propulsive force at certain engine power settings and is generally at a temperature close to or at ambient air temperature. The air traveling within the core gas path 56 ("core gas") is worked within the compressor section 44 to a pressure and temperature higher than ambient. The core gas exits the compressor section 44 and is directed into the combustion section 46 where it is mixed with fuel and combusted. The fuel is provided to the combustion section 46 by a fuel system 58 that draws the fuel from a fuel storage device (e.g., a fuel tank - not shown). Also during operation of the turbine engine 40, a lubrication fluid (e.g., oil) is cycled through propulsion system 26 elements by the propulsion system 26 lubrication system 60. The oil may be cycled to elements of the thermal engine 40 (e.g., bearing housings and the like) and other propulsion system 26 elements such as gearboxes and the like. In many systems, the oil is used to both lubricate and to cool components. As a coolant, the oil removes thermal energy from the respective components and consequently increases in temperature.

Referring to FIG. 4, embodiments of the present invention EGD 62 may be configured to utilize two propulsion system 26 fluids that are in a liquid state, for example lubricating oil and fuel. The liquid oil may be passed through the first fluid conduit 64 and the liquid fuel may be passed through the second fluid conduit 66. The TEGs 68 are disposed between and are in thermal communication with the first fluid conduit 64 and the second fluid conduit 66. The temperature of the oil (Tₒᵢₗ) is greater than the temperature of the fuel (T_{fuel}; Tₒᵢₗ > T_{fuel}) thereby producing a temperature difference across the TEGs 68 that cause the TEGs 68 to produce electrical energy. In some instances, a "two-liquid" EGD 62 as shown in FIG. 4 may be configured as a fuel-oil heat exchanger ("FOHE") that cools hot oil and heats cold fuel sufficiently for purposes of operating the thermal engine 40; i.e., the heat exchange is required during operation of the engine 40. In other instances wherein the aforesaid cooling and heating functions are not required during operation of the engine 40, the present invention EGD 62 may be primarily configured to produce electrical energy while still providing some cooling/heating function. In some instances, a present invention "two-liquid" EGD 62 may be employed in addition to other FOHE structures within the propulsion system 26. In any of the present invention "two-liquid" EGD 62 embodiments that utilize oil and fuel, the motive force and fluid control devices used to pass the liquid oil through the first fluid conduit and/or pass the liquid fuel through the second fluid conduit may be respectively provided by the lubrication system 60 or the fuel system 58 of the propulsion system 26. Alternatively, the present invention may include system components dedicated to the EGD 62 system to provide the fluid motive force and fluid control necessary to pass the fluids through the EGD 62. The liquids utilized within the EGD 62 may have the same or different fluid properties; e.g., viscosity, thermal conductivity, and the like. The present invention may utilize fluid control devices to produce a fluid flow based on the fluid properties for each fluid and/or the difference in temperature across the EGD 62 that is appropriate for the production of electrical energy by the EGD 62. In some embodiments, the configuration of the first fluid conduit 64 and/or the second fluid conduit 66 may be chosen based on the fluid properties (e.g., viscosity, and the like) of the liquid propulsion system 26 fluid passing therethrough.

Referring to FIG. 5, embodiments of the present invention EGD 62 may be configured to utilize one propulsion system fluid in a gaseous state and another propulsion system fluid in a liquid state. In these embodiments, the gaseous propulsion system fluid may be bypass flow or core gas flow, and the liquid propulsion system fluid may be oil or fuel. The first fluid conduit 64 in these embodiments may be as shown in FIG. 4 and 5; i.e., configured to allow passage of a liquid propulsion system fluid (e.g., oil or fuel) therethrough. FIG. 5 diagrammatically illustrates the second fluid conduit 66 as either the bypass duct 54 or the core gas path. FIG. 6 (a partial view of the turbine engine shown in FIG. 3) diagrammatically illustrates an EGD 62 embodiment engaged with the nacelle 24, contiguous with the bypass duct 54, and FIG. 7 (a partial view of the turbine engine shown in FIG. 3) diagrammatically illustrates an EGD 62 embodiment engaged with the engine casing 52, contiguous with the bypass duct 54. In these embodiments, the second fluid conduit 66 of the EGD 62 is the bypass duct 54. FIG. 8 (a partial view of the turbine engine shown in FIG. 3) diagrammatically illustrates an EGD 62 embodiment engaged with the core gas path 56. In this embodiment, the second fluid conduit 66 of the EGD 62 is the core gas path 56. The configurations shown in FIGS. 6-8 are included as non-limiting examples of how an EGD 62 may utilize the bypass duct 54 or the core gas path 56 as a second fluid conduit 66. The TEGs 68 are disposed between the first fluid conduit 64 and the second fluid conduit 66. For purposes of describing these embodiments, the liquid propulsion system fluid will be described as oil. The temperature of the oil (Tₒᵢₗ) is greater than the temperature of the bypass air (T_{bypass}; Tₒᵢₗ > T_{bypass}), or the temperature of the core gas flow (T_{core}; Tₒᵢₗ > T_{core}), thereby producing a temperature difference across the TEGs that cause the TEGs to produce electrical energy. In any of the present invention EGD 62 embodiments that a liquid propulsion system fluid (e.g., oil or fuel), the fluid motive force and fluid control devices used to pass the liquid through the first fluid conduit may be respectively provided by the lubrication system 60 or the fuel system 58 of the propulsion system 26. Alternatively, the present invention may include system components dedicated to the EGD 62 system to provide the fluid motive force and fluid control necessary to pass the fluid through the EGD 62. As indicated above, the present invention may utilize fluid control devices to produce a fluid flow based on the fluid properties for the liquid propulsion system fluid (e.g., oil or fuel) and/or the difference in temperature across the EGD 62 that is appropriate for the production of electrical energy by the EGD 62. In some embodiments, the configuration of the first fluid conduit 64 may be chosen based on the fluid properties (e.g., viscosity, and the like) of the liquid propulsion system fluid passing therethrough.

As indicated above, electrical energy produced by an EGD 62 may be used within the propulsion system 26, or within the aircraft, or both. For example, electrical energy produced by an EGD 62 may be utilized to provide electrical power to electrical needs within the aircraft cabin (e.g., lighting, environmental controls, and the like) and/or propulsion system 26 electrical needs; e.g., control devices, actuators, and the like. When used with a propulsion system 26 in the form of a HEP system 27, the electrical energy produced by an EGD 62 may be directed to the electrical energy storage device for charging purposes. The present invention is not limited to any particular electrical circuitry or controls for providing the electrical energy produced by the EGD 62 to the propulsion system 26 or to the aircraft 20, or any combination thereof.

The examples of the present invention provided above are described in terms of a single EGD 62 to facilitate the description. The present invention contemplates that a propulsion system 26 utilizing a present invention EGD 62 may use a single EGD 62 or a plurality of EGDs 62. In those embodiments that utilize more than one EGD 62, the EGDs 62 may include different configuration EGDs 62; e.g., one or more EGDs 62 that utilize liquid propulsion system fluids and/or one or more EGDs 62 that utilize a liquid propulsion system fluid and a gaseous propulsion system fluid.

The present invention is described herein in terms of liquid propulsion system fluids in the form of oil and fuel, and in terms of gaseous propulsion system fluids in the form of bypass flow and core gas flow. The present invention is not limited to these fluids. The present invention EGDs 62 may be utilized with any two propulsion system fluids that provide a difference in temperature that is sufficient to produce electrical energy within the EGD 62.

The examples provided herein include EGD 62 configurations wherein the first fluid conduit 64 is described as passing a first fluid and the second fluid conduit 66 is described as passing a second fluid. These examples are provided to illustrate the present invention and are not intended to be limiting. The present invention contemplates that an EGD 62 may be configured for use with any two fluids that have a difference in temperature great enough for the TEGs 68 to produce electrical energy.

The terms "substantially", "generally" and/or "about" as contemplated herein are used with refer to a degree of deviation based on experimental error typical for the particular property identified. The latitude provided the terms "substantially", "generally" and/or "about" will depend on the specific context and particular property and can be readily discerned by those skilled in the art. The terms "substantially", "generally" and/or "about" are not intended to either expand or limit the degree of equivalents which may otherwise be afforded a particular value.

While the principles of the invention have been described above in connection with specific apparatuses and methods, it is to be clearly understood that this description is made only by way of example and not as limitation on the scope of the invention. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this invention by way of reference). It is noted that these connections are general and, unless specified otherwise, may be direct or indirect and that this specification is not intended to be limiting in this respect. Any reference to attached, fixed, connected or the like may include permanent, removable, temporary, partial, full and/or any other possible attachment option.

No element, component, or method step in the present invention is intended to be dedicated to the public regardless of whether the element, component, or method step is explicitly recited in the claims. As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the inventions may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the inventions--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements. It is further noted that various method or process steps for embodiments of the present invention are described herein. The description may present method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation.

## Claims

1. An aircraft propulsion system (26), comprising:
a thermal engine (36) configured to produce thrust; and
an electrical energy generating device (62) having a first fluid conduit (64), a second fluid conduit (66), and a thermoelectric generator, TEG (68), wherein the TEG (68) is disposed between the first fluid conduit (64) and the second fluid conduit (66) with a first side of the TEG (68) adjacent the first fluid conduit (64) and a second side of the TEG (68) adjacent the second fluid conduit (66), and wherein the first side of the TEG (68) is in thermal communication with the first fluid conduit (64), and the second side of the TEG (68) is in thermal communication with the second fluid conduit (66), and wherein the TEG (68) is configured to produce electrical energy as a function of a temperature difference across the TEG (68) between the first side of the TEG (68) and the second side of the TEG (68);
wherein the first fluid conduit (64) is configured to contain a first fluid flow, and the second fluid conduit (66) is configured to contain a second fluid flow, and wherein during operation of the propulsion system (26) the first fluid flow is at a first temperature and the second fluid flow is at a second temperature, and the first temperature is higher than the second temperature, thereby producing a said temperature difference across the TEG (68) between the first side of the TEG (68) and the second side of the TEG (68).

2. The aircraft propulsion system (26) of claim 1, further comprising a lubrication system (60) configured to cycle a lubricant flow within the propulsion system (26), wherein the first fluid flow is the lubricant flow.

3. The aircraft propulsion system (26) of claim 1 or 2, further comprising a fuel system (58) configured to provide a fuel flow to the thermal engine (36), wherein the second fluid flow is the fuel flow.

4. The aircraft propulsion system (26) of claim 1 or 2, wherein the thermal engine (36) is a gas turbine engine (40) that is disposed within a nacelle (24), the gas turbine engine (40) including a fan section (42), a compressor section (44), a combustion section (46), a turbine section (48), and an engine casing (52) disposed radially outside of the compressor section (44), the combustion section (46), and the turbine section (48);
wherein an annular bypass duct (54) is defined between the engine casing (52) and an interior structure of the nacelle (24), and the bypass duct (54) is configured to contain a bypass flow during operation of the propulsion system (26); and
wherein the second fluid flow is the bypass flow.

5. The aircraft propulsion system (26) of claim 4, wherein the bypass duct (54) is the second fluid conduit (66).

6. The aircraft propulsion system (26) of any of claim 1 or 2, wherein the thermal engine (36) is a gas turbine engine (40) that includes a fan section (42), a compressor section (44), a combustion section (46), a turbine section (48), and a core gas path (56) that extends through the compressor section (44), the combustion section (46), and the turbine section (48);
wherein the core gas path (56) is configured to contain a core gas flow during operation of the propulsion system (26); and
wherein the second fluid flow is the core gas flow.

7. The aircraft propulsion system (26) of claim 6, wherein the core gas path (56) is the second fluid conduit (66).

8. A hybrid electric propulsion, HEP, system (27) for an aircraft (20), comprising:
a thermal engine (36);
an electric motor (32);
a gearbox (34) in communication with the thermal engine (36) and the electric motor (32);
an electric power storage unit (28); and
an electrical energy generating device (62) having a first fluid conduit (64), a second fluid conduit (66), and a thermoelectric generator, TEG (68), wherein the TEG (68) is disposed between the first fluid conduit (64) and the second fluid conduit (66) with a first side of the TEG (68) adjacent the first fluid conduit (64) and a second side of the TEG (68) adjacent the second fluid conduit (66), and wherein the first side of the TEG (68) is in thermal communication with the first fluid conduit (64), and the second side of the TEG (68) is in thermal communication with the second fluid conduit (66), and wherein the TEG (68) is configured to produce electrical energy as a function of a temperature difference across the TEG (68) between the first side of the TEG (68) and the second side of the TEG (68);
wherein the first fluid conduit (64) is configured to contain a first fluid flow, and the second fluid conduit (66) is configured to contain a second fluid flow, and wherein during operation of the HEP system (27) the first fluid flow is at a first temperature and the second fluid flow is at a second temperature, and the first temperature is higher than the second temperature, thereby producing the temperature difference across the TEG (68) between the first side of the TEG (68) and the second side of the TEG (68).

9. The HEP system (27) of claim 8, further comprising:
a lubrication system (60) configured to cycle a lubricant flow within the HEP system (27), wherein the first fluid flow is the lubricant flow; and/or
a fuel system (58) configured to provide a fuel flow to the thermal engine (36), wherein the second fluid flow is the fuel flow.

10. The HEP system (27) of claim 8, wherein the thermal engine (36) is a gas turbine engine (40) that is disposed within a nacelle (24), the gas turbine engine (40) including a fan section (42), a compressor section (44), a combustion section (46), a turbine section (48), and an engine casing (52) disposed radially outside of the compressor section (44), the combustion section (46), and the turbine section (48);
wherein an annular bypass duct (54) is defined between the engine casing (52) and an interior structure of the nacelle (24), and the bypass duct (54) is configured to contain a bypass flow during operation of the propulsion system (26); and
wherein the second fluid flow is the bypass flow and the bypass duct (54) is the second fluid conduit (66); and
wherein the HEP system (27) includes a lubrication system (60) configured to cycle a lubricant flow within the HEP system (27), wherein the first fluid flow is the lubricant flow.

11. The aircraft propulsion system of any of claims 1 to 7, or the HEP system of any of claims 8 to 10, wherein the TEG is configured to use a Seebeck effect.

12. A method of generating electrical energy within a propulsion system (26) of an aircraft (20), the comprising:
providing a propulsion system (26) having a thermal engine (36);
providing an electrical energy generating device (62) having a first fluid conduit (64), a second fluid conduit (66), and a thermoelectric generator, TEG (68), wherein the TEG (68) is disposed between the first fluid conduit (64) and the second fluid conduit (66) with a first side of the TEG (68) adjacent the first fluid conduit (64) and a second side of the TEG (68) adjacent the second fluid conduit (66), and wherein the first side of the TEG (68) is in thermal communication with the first fluid conduit (64), and the second side of the TEG (68) is in thermal communication with the second fluid conduit (66), and wherein the TEG (68) is configured to generate electrical energy as a function of a temperature difference across the TEG (68) between the first side of the TEG (68) and the second side of the TEG (68); and
using the electrical energy generating device (62) to generate electrical energy by:
directing a first fluid flow through the first fluid conduit (64) during operation of the propulsion system (26), wherein the first fluid flow is at a first temperature; and
directing a second fluid flow through the second fluid conduit (66) during operation of the propulsion system (26), wherein the second fluid flow is at a second temperature, and the first temperature is higher than the second temperature, thereby producing the temperature difference across the TEG (68) between the first side of the TEG (68) and the second side of the TEG (68), which in turn causes the TEG (68) to generate electrical energy.

13. The method of claim 12, wherein the propulsion system (26) includes:
a lubrication system (60) configured to cycle a lubricant flow within the propulsion system (26), and wherein the first fluid flow is the lubricant flow; and/or
a thermal engine (36) fuel system (58) configured to provide a fuel flow to the thermal engine (36), and wherein the second fluid flow is the fuel flow.

14. The method of claim 12, wherein the thermal engine (36) is a gas turbine engine (40) that is disposed within a nacelle (24), the gas turbine engine (40) including a fan section (42), a compressor section (44), a combustion section (46), a turbine section (48), and an engine casing (52) disposed radially outside of the compressor section (44), the combustion section (46), and the turbine section (48);
wherein an annular bypass duct (54) is defined between the engine casing (52) and an interior structure of the nacelle (24), and the bypass duct (54) is configured to contain a bypass flow during operation of the propulsion system (26); and
wherein the second fluid flow is the bypass flow and the bypass duct (54) is the second fluid conduit (66); and
wherein the propulsion system (26) includes a lubrication system (60) configured to cycle a lubricant flow within the HEP system (27), wherein the first fluid flow is the lubricant flow.

15. The method of any of claims 12 to 14, wherein the propulsion system (26) is a hybrid electric propulsion system (26) and the TEG (68) is configured to use a Seebeck effect.
